# FASCICULE DE BREVET EUROPEEN

(11) **EP 4 082 040 B1**
(45) Date de publication et mention de la délivrance du brevet: **01.05.2024**
(21) Numéro de dépôt: 20823851.9
(22) Date de dépôt: 16.12.2020
(51) Int. Cl.: H01L 25/075, H01L 33/62

(54) **AFFICHEUR À MICROLEDS À ÉMISSION AU TRAVERS DE LA MATRICE ACTIVE**
MIKRO-LED-ANZEIGE, DIE DURCH DIE AKTIVE MATRIX EMITTIERT
MICRO-LED DISPLAY EMITTING THROUGH THE ACTIVE MATRIX

(30) Priorité: 26.12.2019 FR 1915601
(43) Date de publication de la demande: 02.11.2022
(73) Titulaire: THALES, 92190 Meudon (FR)
(72) Inventeur: LEBRUN, Hugues, 38500 COUBLEVIE (FR)
(74) Mandataire: Atout PI Laplace
(86) Numéro de dépôt international: PCT/EP2020/086372
(87) Numéro de publication internationale: WO 2021/130073

(56) Documents cités:
- US-A1- 2017 194 304
- US-A1- 2019 148 409

## Description

L'invention se situe dans le domaine des afficheurs à écran plat que l'on connaît également sous le terme de « display ». Actuellement, il existe deux grands types de technologies d'affichage. La première technologie consiste à mettre en oeuvre une matrice à cristaux liquides éclairée par des diodes électroluminescentes ou « LED » dont l'éclairage est constant. La cellule à cristaux liquides joue le rôle de modulateur spatial d'intensité pour former l'image.

La seconde technologie consiste à mettre en oeuvre une matrice de diodes électroluminescentes réalisées en matériau organique ou « OLED » pour former directement l'image. Plus précisément, un pixel élémentaire couleur de l'image est constitué de trois diodes émettant dans trois couleurs différentes qui sont typiquement le vert, le rouge et le bleu. Dans cette technologie, les OLEDs ont le rôle de source de lumière et de modulateur.

Les OLEDs sont réalisées principalement à l'aide d'un empilement de couches minces ayant des fonctions caractéristiques des diodes électroluminescentes telles qu'une couche dopée n pour amener les électrons, une couche dopée p pour amener les trous et une couche intrinsèque de recombinaison pour l'émission des photons. Ces couches minces sont déposées sous vide ou par jet d'encre directement sur une matrice de transistors dont la fonction est le contrôle du courant, donc de l'intensité lumineuse émise dans l'OLED en chaque point de l'image. Dans la suite de la description, cette matrice électronique est appelée matrice active.

Une troisième technologie très prometteuse émerge depuis quelques années : les µLEDs ou diodes électroluminescentes inorganiques. Ces diodes sont appelées µLEDs, compte-tenu de leurs très faibles dimensions, de l'ordre de 100 micromètres.

Dans cette dernière technologie, les diodes électroluminescentes ne sont plus déposées en couches minces sur la matrice active. Il s'agit de composants discrets réalisés le plus souvent sur saphir, silicium ou carbure de silicium qui sont reportés et connectés a postériori sur la plaque de verre qui supporte la matrice active. Ces µLEDs jouent alors de la même façon que les OLEDs le rôle de sources et de modulateurs de lumière.

Dans un dispositif d'affichage à LEDs qu'elles soient organiques ou inorganiques à matrice active, il est préférable que l'émission de lumière se fasse du côté opposé à la matrice active. De cette façon, les lignes, les colonnes et les transistors de la matrice active qui constituent le dispositif de commande des LEDs ne font pas obstacle à la transmission de la lumière. Toute la surface de l'émetteur est alors utilisée pour l'émission de lumière.

Cependant, cela impose que les contacts des LEDs soient positionnés sur la face opposée à leur face d'émission. Cette disposition présente plusieurs difficultés de réalisation.

Dans le cas des dispositifs d'affichage dans lesquels les LEDs sont des composants discrets reportés sur la matrice active, le procédé de fabrication des LEDs sur substrat de saphir ou de silicium donne des composants qui naturellement ont leur surface d'émission d'un même côté que les contacts.

Dans tous les cas, la réalisation de composants couleurs comportant une émission du côté opposé aux contacts électriques impose un amincissement ou une élimination du substrat initial.

Cette élimination ou cet amincissement sont nécessaires pour permettre la transmission de la lumière, par exemple lorsque le substrat est en silicium. Cette élimination ou cet amincissement sont également nécessaires pour permettre la réalisation des couches de conversion de couleur du côté de l'émission, par exemple lorsque le substrat est en saphir ou en silicium. Cela entraîne de multiples transferts des LEDs vers différents substrats avant d'obtenir un composant final dont le contact soit du côté de la matrice active et la zone d'émission vers le côté opposé à travers une couche de conversion de couleur.

Ces multiples opérations d'amincissements ou de transferts de substrats sont coûteuses. Elles ont un rendement de fabrication aléatoire. Elles provoquent une fragilisation du composant et limitent les températures et les pressions utilisables pour le procédé d'assemblage et de connexion des LEDs sur la matrice active.

Par conséquent, les solutions d'affichage à émission des LEDs à travers la matrice active présentent moins de difficultés de fabrication. Le document US 2017/194304 A1 décrit un afficheur à micro-LEDs.

L'afficheur à µLEDs selon l'invention s'inscrit dans ce cadre, c'est-à-dire celui des afficheurs émettant à travers la matrice active. L'invention a un triple objectif :
- Limiter le nombre d'étapes de fabrication de la LED sur son substrat. Il n'est alors pas nécessaire de fabriquer un contact sur sa face d'émission ;
- Réduire le nombre de contacts entre la matrice active et les LEDs ;
- Réduire le nombre d'alimentations distribuées sur la plaque de verre utilisée comme support de la matrice active. En effet, l'alimentation par la face opposée à la matrice active passe préférentiellement par un plan conducteur déporté sur cette face du dispositif.

Un objet de l'invention est donc un afficheur à µLEDs comportant une pluralité de puces électroniques à µLEDs et une matrice active de commande desdites puces à µLEDs, la matrice active étant montée sur une lame transparente, chaque puce à µLEDs comportant plusieurs diodes électroluminescentes, chaque puce à µLEDs comprenant un substrat comportant sur sa partie inférieure une surface conductrice faisant office d'électrode commune et sur sa partie supérieure les µLEDs et leurs contacts électriques de commande, l'afficheur comportant au moins, dans cet ordre :
- Une plaque support comportant une face inférieure et une face supérieure ;
- Un ou plusieurs premiers plans électriques d'alimentation disposés sur la face supérieure de la plaque support ;
- Une pluralité de premiers éléments conducteurs ;
- La pluralité de puces électroniques, un premier élément conducteur assurant la liaison électrique entre l'électrode commune de chaque puce et un premier plan électrique d'alimentation ;
- Une pluralité de seconds éléments conducteurs, chaque second élément conducteur étant disposé sur un contact électrique de commande d'une puce électronique ;
- La lame transparente portant la matrice active, chaque second élément conducteur assurant la liaison électrique entre un contact électrique d'une puce électronique et un contact électrique de commande de la matrice active.

Avantageusement, le plan électrique d'alimentation est commun à l'ensemble des puces électroniques.

Avantageusement, un second plan électrique d'alimentation est disposé sur la face inférieure de la plaque support.

Avantageusement, le second plan électrique d'alimentation est relié électriquement à la face supérieure de la plaque support au moyen de vias conducteurs assurant la liaison électrique entre le premier plan électrique d'alimentation et le second plan électrique d'alimentation.

Avantageusement, un élément de dissipation thermique est fixé sous la plaque support.

Avantageusement, un troisième plan électrique d'alimentation est disposé sur la face inférieure de la plaque support, ledit troisième plan électrique d'alimentation étant relié électriquement au moyen de vias conducteurs à des plages métalliques ou conductrices indépendantes du premier plan électrique ou du second plan électrique placées sur la face supérieure de la plaque support, une pluralité de troisièmes éléments conducteurs assurant la liaison électrique entre chaque via et un contact électrique d'alimentation de la matrice active.

Avantageusement, la plaque support est un circuit imprimé multicouches comportant plusieurs couches conductrices isolées électriquement.

Avantageusement, la plaque support comporte des logements dans lesquels s'insèrent les puces électroniques.

Avantageusement, la plaque support comporte des premiers plots conducteurs disposés sur chaque via et dont la hauteur est égale à celle des puces électroniques.

Avantageusement, la lame transparente comporte des seconds plots conducteurs disposés en regard de chaque via et dont la hauteur est égale à celle des puces électroniques.

Avantageusement, la plaque support est transparente, les plans électriques d'alimentation étant des grilles comportant des plots conducteurs disposés sous les µLEDs.

Avantageusement, la plaque support est en verre ou en polytéréphtalate d'éthylène.

Avantageusement, les grilles sont recouvertes d'un matériau absorbant la lumière.

Avantageusement, l'espace séparant le premier plan électrique d'alimentation et la lame transparente portant la matrice active est rempli d'un matériau isolant transparent ou opaque.

Avantageusement, les puces sont toutes identiques, chaque puce comportant au moins trois diodes électroluminescentes, chaque diode électroluminescente émettant dans une bande spectrale différente de celles des deux autres diodes électroluminescentes.

Avantageusement, les puces sont d'au moins trois types, chaque type de puce comportant une ou plusieurs diodes électroluminescentes identiques, les diodes électroluminescente d'un type de puce émettant dans une bande spectrale différente de celles des diodes électroluminescentes des deux autres types de puce.

D'autres caractéristiques, détails et avantages de l'invention ressortiront à la lecture de la description faite en référence aux dessins annexés donnés à titre d'exemple et qui représentent, respectivement :
[Fig.1] une vue en coupe d'une puce électronique à diodes électroluminescentes selon l'invention ;
[Fig.2] une vue en coupe partielle d'un premier mode de réalisation d'un afficheur à µLEDs selon l'invention comportant un plan d'alimentation ;
[Fig.3] une vue en coupe partielle d'un second mode de réalisation d'un afficheur à µLEDs selon l'invention comportant deux plans d'alimentation ;
[Fig.4] une vue de dessus partielle d'un plan d'alimentation d'un afficheur semi-transparent selon l'invention.

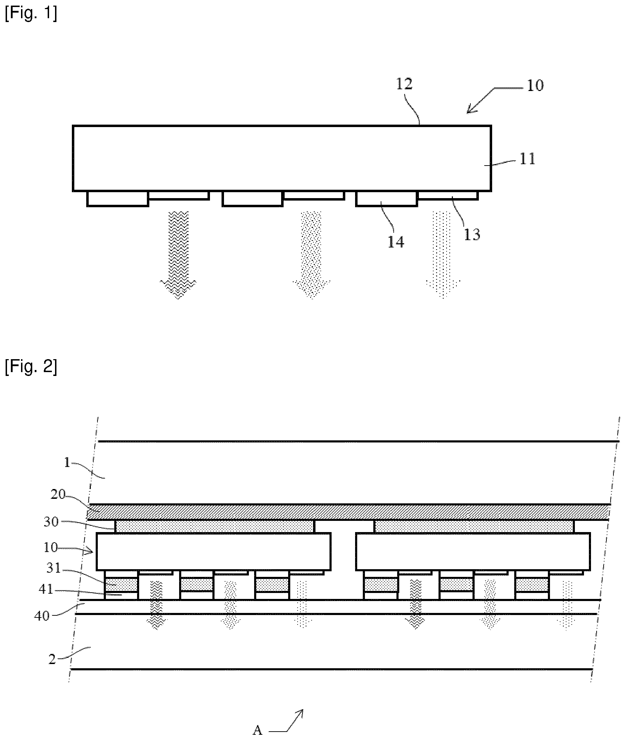

L'afficheur selon l'invention est constitué d'une matrice ou d'une mosaïque de puces électroniques à µLEDs. La figure 1 représente une vue en coupe d'une puce électronique 10 à µLEDS de cet afficheur. Cette puce comporte un substrat 11 comportant une face inférieure et une face supérieure. Préférentiellement, le substrat est conducteur et comporte naturellement une surface inférieure conductrice 12 qui va servir d'électrode commune à toutes les diodes à la condition que cette face arrière ne soit pas oxydée ou que la couche d'oxydation puisse être traitée pour favoriser la reprise de contact électrique. Le substrat est généralement en silicium dopé. La face supérieure porte les µLEDS émettrices 13 et leurs contacts de commande 14, un contact étant associé à chaque diode. Pour chaque diode 13, le contact électrique de commande 14 est disposé à coté de ladite diode de façon à ne pas couvrir une surface de ladite diode. Les émissions lumineuses des diodes sont symbolisées par des flèches sur cette figure 1 et les suivantes. Elles sont du même côté que les contacts de commande.

Il existe différentes variétés de puces selon les diodes électroluminescentes associées. Une première variété de puce comporte un ou plusieurs triplets de diodes. Chaque triplet est composé de trois diodes électroluminescentes, chaque diode électroluminescente émettant dans une bande spectrale différente de celles des deux autres diodes électroluminescentes. Classiquement, une des diodes émet dans le rouge, une seconde diode dans le vert et la troisième dans le bleu. Chaque triplet correspond à un pixel coloré de l'imageur.

Une seconde variété de puces comporte uniquement des diodes émettant dans la même bande spectrale. Il existe alors trois types de puces selon la couleur d'émission de leurs diodes respectives. Par exemple, un premier type de puce comporte des diodes émettant dans le rouge, un second type de puce comporte des diodes émettant dans le vert, un troisième type de puce comporte des diodes émettant dans le bleu. En juxtaposant convenablement les puces de type différent selon une mosaïque périodique, on recrée des pixels comportant chacun un triplet de diodes électroluminescentes colorées différentes.

Les dimensions des puces électroniques sont de l'ordre de grandeur des pixels de l'afficheur, soit quelques centaines de microns. Les puces sont généralement de forme géométrique simple comme le rectangle, le carré, le triangle, le losange, le trapèze ou l'hexagone de façon à pouvoir réaliser des pavages périodiques.

La figure 2 représente une vue en coupe partielle d'un premier mode de réalisation d'un afficheur A à µLEDs selon l'invention. Sur cette vue, deux puces 10 sont représentées. L'afficheur comporte au moins, dans cet ordre :
- Une plaque support 1 comportant une face inférieure et une face supérieure ;
- Un ou plusieurs premiers plans électriques d'alimentation 20 disposés sur la face supérieure de la plaque support 1 ;
- Une pluralité de premiers éléments conducteurs 30 ;
- Une pluralité de puces électroniques 10 telles que définies précédemment, un premier élément conducteur 30 assurant la liaison électrique entre l'électrode commune de chaque puce et un premier plan électrique d'alimentation 20 ;
- Une pluralité de seconds éléments conducteurs 31, chaque second élément conducteur étant disposé sur un contact électrique de commande d'une puce électronique ;
- Une lame transparente 2 portant une matrice active 40, chaque second élément conducteur 31 assurant la liaison électrique entre un contact électrique d'une puce électronique et un contact électrique 41 de commande de la matrice active 40.

La plaque support 1 peut être en différents matériaux susceptibles de porter un conducteur métallique. A titre d'exemples non limitatifs, on citera le verre, l'époxy ou le polytéréphtalate d'éthylène, connu sous l'acronyme « PET ». Le matériau peut être rigide ou flexible comme le PET si son épaisseur est suffisamment mince. Si l'afficheur est transparent, la plaque support est nécessairement réalisée dans un matériau transparent comme le verre ou le PET. Les afficheurs transparents permettent d'afficher une image en superposition sur l'extérieur.

Les plans électriques d'alimentation peuvent être réalisés en tous types de matériaux électriquement conducteurs. On utilisera préférentiellement des métaux à très faible résistivité comme le cuivre ou l'aluminium.

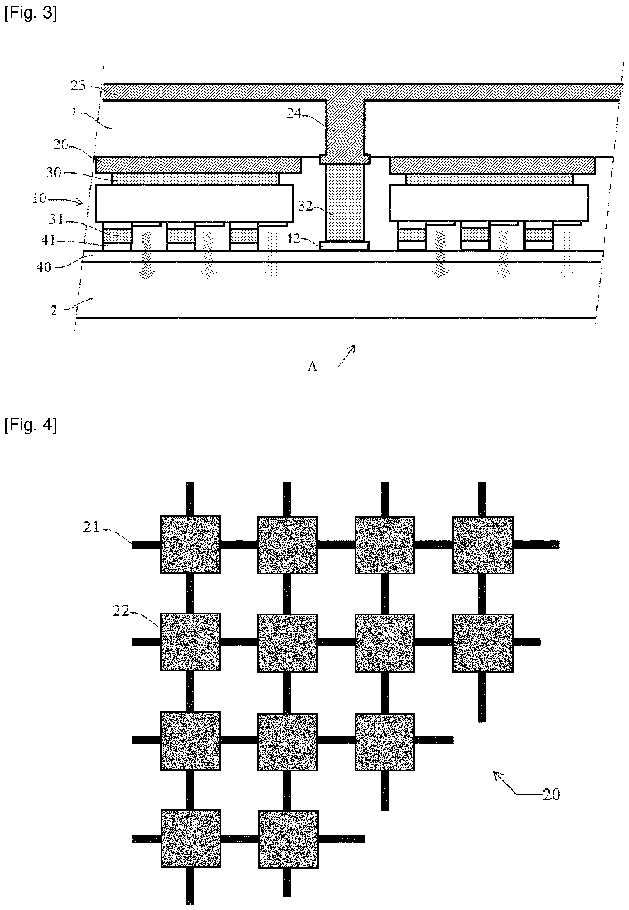

Si l'afficheur est opaque, il est préférable de noircir le métal des plans électriques hors des plages de reprises de contact avec les électrodes pour réduire la réflexion de la lumière ambiante par l'afficheur. Si l'afficheur est transparent, il faut réduire au maximum l'empreinte du plan électrique d'alimentation. A cet effet, comme il est indiqué sur la figure 4, le plan métallique 20 peut être une grille 21 organisée en lignes et en colonnes comportant des plages de report 22 situées au niveau des électrodes de façon que cette grille laisse passer la lumière externe. De la même façon, cette grille peut être noircie pour diminuer la lumière parasite.

Pour réduire la résistance d'accès au centre de l'afficheur, le plan conducteur peut être placé sur les deux faces de la plaque support avec des trous métalliques en vis à vis de chaque µLED. Ces trous métalliques ou via ont alors deux fonctions qui sont :
- La distribution de tension homogène et uniforme sur toute la surface de l'afficheur ;
- L'évacuation de la chaleur générée au niveau de chaque puce. Dans ce dernier cas, un élément de dissipation de chaleur peut être collé sur la face arrière. Le via sert alors de caloduc entre la puce et ce radiateur.

Les premiers éléments conducteurs 30 et les seconds éléments conducteurs 31 sont préférentiellement réalisés en colle conductrice. Celle-ci peut être isotrope ou anisotrope. Elle peut être solide sous la forme d'un ruban de colle contenant des éléments conducteurs de petite taille laminé sur le plan conducteur ou se présenter sous la forme d'une pâte contenant des éléments conducteurs de petite taille. Les éléments conducteurs peuvent être des paillettes de métal ou des billes métalliques ou des billes isolantes recouverts d'une fine couche de métal. La pâte peut être placée sur les LEDs ou sur le plan conducteur à l'emplacement précis des LEDs par dispense à l'aide d'une seringue ou par sérigraphie, par exemple.

Pour réduire les risques de courts circuits entre le plan conducteur et les pistes métalliques sur la matrice active, il peut être avantageux de remplir l'espace entre les LEDs avec un matériau isolant de type résine ou colle. Ce matériau peut être transparent ou noir opaque de façon à isoler optiquement les puces à µLED. Le remplissage de cette espace peut être réalisé avant, pendant ou après le report du plan conducteur.

On sait que, pour alimenter une diode, il faut disposer d'une tension d'alimentation positive, souvent nommée VDD et d'une tension d'alimentation négative, souvent identifiée à la masse GND ou à VSS par lesquels s'écoule le courant électrique nécessaire à l'émission de lumière.

Les impédances d'accès élevées dans les plans d'alimentation provoquent des chutes de tension dans les plans conducteurs. Elles contraignent à l'utilisation de tensions d'alimentation nettement supérieures à la tension minimale d'alimentation des LEDs et des transistors et donc à une surconsommation d'énergie. Les deux plans d'alimentation peuvent être situés sur la face supérieure de la plaque support. Il est également possible de les disposer sur les deux faces de la plaque support.

La figure 3 représente une vue en coupe partielle d'un mode de réalisation d'un afficheur A à µLEDs selon l'invention reprenant cette disposition des plans d'alimentation. Sur cette vue, deux puces sont représentées. Les différentes références sont les mêmes que sur la vue de la figure 2.

Dans cette configuration, un plan électrique d'alimentation 23 est disposé sur la face inférieure de la plaque support 1. Ce plan électrique 23 d'alimentation est relié électriquement au moyen de vias conducteurs 24 à des plages métalliques ou conductrices indépendantes du premier plan électrique ou du second plan électrique placées à la face supérieure de la plaque support, une pluralité de troisièmes éléments conducteurs 32 assurant la liaison électrique entre chaque via 24 et un contact électrique d'alimentation 42 de la matrice active 40.

L'une des tensions est alors directement connectée à l'électrode commune à toute les µLEDs sur une même puce. La seconde tension est connectée au drain ou à la source de tous les transistors de commande des µLEDs sur la matrice active. Il est donc nécessaire d'avoir deux alimentations distribuées sur l'ensemble du dispositif.

Il est cependant difficile d'obtenir des plans d'alimentations ayant des impédances d'accès faibles lorsqu'ils sont réalisés en couches minces avec des épaisseurs inférieures à 1 µm sur la matrice active.

Il est préférable d'utiliser une plaque support ayant la possibilité de supporter plusieurs couches métalliques isolées électriquement telle qu'un circuit imprimé multicouches. Il est également nécessaire que les puces supportant les µLEDs soient significativement espacées sur la matrice active de façon à libérer de l'espace pour les zones de contact vers le plan d'alimentation sur la matrice active.

La difficulté de l'opération de reprise de contact tient au fait que les contacts sur la matrice active et sur le silicium en face arrière des puces ne sont pas à la même altitude comme on le voit sur la figure 3 où les éléments conducteurs 31 et 32 ont des hauteurs différentes. Quatre solutions techniques sont possibles pour compenser cette différence d'altitude.

La première solution consiste à utiliser des volumes de colle conductrice isotrope différents selon que la colle est placée sur un plot de contact pour le plan d'alimentation de la matrice active ou pour le plan d'alimentation du silicium en face arrière des LEDs.

La seconde solution consiste à utiliser un circuit imprimé comportant des cavités ménagées à l'emplacement des LEDs et une électrode métallique en fond de chaque cavité pour recevoir l'élément conducteur pour la reprise de contact sur le silicium. La reprise de contact pour l'alimentation de la matrice active est placée sur la face supérieure du circuit imprimé comme cela est présenté sur la figure 3. Cela permet d'utiliser le même élément conducteur pour les deux types de contact ou pour les deux plans d'alimentation.

La troisième solution consiste à mettre en place sur le circuit imprimé des cales métalliques en surépaisseur par rapport à la face du circuit imprimé. Ces cales sont placées en vis à vis des plages de reprise de contact de la matrice active.

La quatrième solution consiste à mettre en place sur la plaque de verre d'éléments métalliques d'une épaisseur identique à celle du silicium et connectés au plan d'alimentation de la matrice active. Ces éléments métalliques répartis sur la matrice active sont connectés d'un coté au plan d'alimentation sur le verre et de l'autre coté sur les plages de contact de l'un des plans d'alimentation du circuit imprimé. Dans ce dernier cas, les plots métalliques sur le verre peuvent être connectés simultanément et avec la même solution de prise de contact que les puces supportant les µLEDs. Il peut s'agir de plots de silicium dopés de la même épaisseur que ceux utilisés pour supporter les µLEDs.

## Revendications

1. Afficheur à µLEDs comportant une pluralité de puces électroniques (10) à µLEDs et une matrice active (40) de commande desdites puces à µLEDs, la matrice active étant montée sur une lame transparente (2), chaque puce (10) à µLEDs comportant plusieurs diodes électroluminescentes (13), chaque puce à µLEDs comprenant un substrat (11) comportant sur sa partie inférieure une surface conductrice (12) faisant office d' électrode commune et sur sa partie supérieure les µLEDs (13) et leurs contacts électriques (14) individuels de commande, l'afficheur comportant au moins, dans cet ordre :
- Une plaque support (1) comportant une face inférieure et une face supérieure ;
- Un ou plusieurs premiers plans électriques d'alimentation (20) disposés sur la face supérieure de la plaque support ;
- Une pluralité de premiers éléments conducteurs (30) ;
- La pluralité de puces électroniques (10), un premier élément conducteur assurant la liaison électrique entre l'électrode commune de chaque puce et un premier plan électrique d'alimentation ;
- Une pluralité de seconds éléments conducteurs (31), chaque second élément conducteur étant disposé sur un contact électrique de commande d'une puce électronique ;
- La lame transparente (2) portant la matrice active (40), chaque second élément conducteur assurant la liaison électrique entre un contact électrique d'une puce électronique et un contact électrique (41) de commande de la matrice active.

2. Afficheur à µLEDs selon la revendication 1, dans lequel le plan électrique d'alimentation est commun à l'ensemble des puces électroniques.

3. Afficheur à µLEDs selon la revendication 1, dans lequel un second plan électrique d'alimentation est disposé sur la face inférieure de la plaque support.

4. Afficheur à µLEDs selon la revendication 3, dans lequel ledit second plan électrique d'alimentation est relié électriquement à la face supérieure de la plaque support au moyen de vias conducteurs assurant la liaison électrique entre le premier plan électrique d'alimentation et le second plan électrique d'alimentation.

5. Afficheur à µLEDs selon la revendication 3, dans lequel un élément de dissipation thermique est fixé sous la plaque support.

6. Afficheur à µLEDs selon la revendication 1, dans lequel un troisième plan électrique d'alimentation (23) est disposé sur la face inférieure de la plaque support, ledit troisième plan électrique d'alimentation étant relié électriquement au moyen de vias conducteurs (24) à des plages métalliques ou conductrices indépendantes du premier plan électrique ou du second plan électrique placées sur la face supérieure de la plaque support, une pluralité de troisièmes éléments conducteurs (32) assurant la liaison électrique entre chaque via et un contact électrique d'alimentation de la matrice active.

7. Afficheur à µLEDs selon la revendication 6, dans lequel la plaque support est un circuit imprimé multicouches comportant plusieurs couches conductrices isolées électriquement.

8. Afficheur à µLEDs selon la revendication 6, dans lequel la plaque support comporte des logements dans lesquels s'insèrent les puces électroniques.

9. Afficheur à µLEDs selon la revendication 6, dans lequel la plaque support comporte des premiers plots conducteurs disposés sur chaque via et dont la hauteur est égale à celle des puces électroniques.

10. Afficheur à µLEDs selon la revendication 6, dans lequel la lame transparente comporte des seconds plots conducteurs disposés en regard de chaque via et dont la hauteur est égale à celle des puces électroniques.

11. Afficheur à µLEDs selon l'une des revendications 1 à 5, dans lequel la plaque support est transparente, les plans électriques d'alimentation étant des grilles (21) comportant des plots conducteurs (22) disposés sous les µLEDs.

12. Afficheur à µLEDs selon la revendication 11, dans lequel la plaque support est en verre ou en polytéréphtalate d'éthylène

13. Afficheur à µLEDs selon la revendication 11, dans lequel les grilles sont recouvertes d'un matériau absorbant la lumière.

14. Afficheur à µLEDs selon l'une des revendications précédentes, dans lequel l'espace séparant le premier plan électrique d'alimentation et la lame transparente portant la matrice active est rempli d'un matériau isolant.

15. Afficheur à µLEDs selon la revendication 14, dans lequel le matériau isolant est transparent.

16. Afficheur à µLEDs selon la revendication 14, dans lequel le matériau isolant est opaque.

17. Afficheur à µLEDs selon l'une des revendications précédentes, dans lequel les puces sont toutes identiques, chaque puce comportant au moins trois diodes électroluminescentes, chaque diode électroluminescente émettant dans une bande spectrale différente de celles des deux autres diodes électroluminescentes.

18. Afficheur à µLEDs selon l'une des revendications 1 à 16, dans lequel les puces sont d'au moins trois types, chaque type de puce comportant plusieurs diodes électroluminescentes identiques, les diodes électroluminescente d'un type de puce émettant dans une bande spectrale différente de celles des diodes électroluminescentes des deux autres types de puce.

## Patentansprüche

1. µLED-Display, das eine Vielzahl von µLED-Chips (10) und eine aktive Matrix (40) zur Steuerung der µLED-Chips aufweist, wobei die aktive Matrix auf einer transparenten Platte (2) montiert ist, wobei jeder µLED-Chip (10) mehrere Leuchtdioden (13) aufweist, wobei jeder µLED-Chip ein Substrat (11) umfasst, das an seinem unteren Teil eine als gemeinsame Elektrode fungierende leitfähige Fläche (12) und an seinem oberen Teil die µLEDs (13) und ihre individuellen elektrischen Steuerkontakte (14) aufweist, wobei das Display, in dieser Reihenfolge, mindestens Folgendes aufweist:
- eine Trägerplatte (1) mit einer Unterseite und einer Oberseite;
- eine oder mehrere erste elektrische Versorgungsebenen (20), die auf der Oberseite der Trägerplatte angeordnet sind;
- eine Vielzahl von ersten leitfähigen Elementen (30);
- die Vielzahl von Chips (10), wobei ein erstes leitfähiges Element die elektrische Verbindung zwischen der gemeinsamen Elektrode jedes Chips und einer ersten elektrischen Versorgungsebene bereitstellt;
- eine Vielzahl von zweiten leitfähigen Elementen (31), wobei jedes zweite leitfähige Element auf einem elektrischen Steuerkontakt eines Chips angeordnet ist;
- die die aktive Matrix (40) tragende transparente Platte (2), wobei jedes zweite leitfähige Element die elektrische Verbindung zwischen einem elektrischen Kontakt eines Chips und einem elektrischen Steuerkontakt (41) der aktiven Matrix bereitstellt.

2. µLED-Display nach Anspruch 1, wobei die elektrische Versorgungsebene allen Chips gemeinsam ist.

3. µLED-Display nach Anspruch 1, wobei eine zweite elektrische Versorgungsebene auf der Unterseite der Trägerplatte angeordnet ist.

4. µLED-Display nach Anspruch 3, wobei die zweite elektrische Versorgungsebene mittels leitfähiger Durchkontaktierungen, die die elektrische Verbindung zwischen der ersten elektrischen Versorgungsebene und der zweiten elektrischen Versorgungsebene bereitstellen, elektrisch mit der Oberseite der Trägerplatte verbunden ist.

5. µLED-Display nach Anspruch 3, wobei ein Wärmeableitungselement unter der Trägerplatte befestigt ist.

6. µLED-Display nach Anspruch 1, wobei eine dritte elektrische Versorgungsebene (23) auf der Unterseite der Trägerplatte angeordnet ist, wobei die dritte elektrische Versorgungsebene mittels leitfähiger Durchkontaktierungen (24) zu von der ersten elektrischen Ebene oder der zweiten elektrischen Ebene unabhängigen, auf der Oberseite der Trägerplatte platzierten Metall- oder Leiterflächen elektrisch verbunden ist, wobei eine Vielzahl von dritten leitfähigen Elementen (32) die elektrische Verbindung zwischen jeder Durchkontaktierung und einem elektrischen Versorgungskontakt der aktiven Matrix bereitstellt.

7. µLED-Display nach Anspruch 6, wobei die Trägerplatte eine mehrschichtige Leiterplatte mit mehreren elektrisch isolierten leitfähigen Schichten ist.

8. µLED-Display nach Anspruch 6, wobei die Trägerplatte Aufnahmen aufweist, in die die Chips eingesetzt werden.

9. µLED-Display nach Anspruch 6, wobei die Trägerplatte erste leitfähige Pads aufweist, die auf jeder Durchkontaktierung angeordnet sind und deren Höhe gleich der der Chips ist.

10. µLED-Display nach Anspruch 6, wobei die transparente Platte zweite leitfähige Pads aufweist, die gegenüber jeder Durchkontaktierung angeordnet sind und deren Höhe gleich der der Chips ist.

11. µLED-Display nach einem der Ansprüche 1 bis 5, wobei die Trägerplatte transparent ist, wobei die elektrischen Versorgungsebenen Gitter (21) sind, die unter den µLEDs angeordnete leitfähige Pads (22) aufweisen.

12. µLED-Display nach Anspruch 11, wobei die Trägerplatte aus Glas oder Polyethylenterephthalat besteht.

13. µLED-Display nach Anspruch 11, wobei die Gitter mit einem lichtabsorbierenden Material beschichtet sind.

14. µLED-Display nach einem der vorhergehenden Ansprüche, wobei der Raum, der die erste elektrische Versorgungsebene und die die aktive Matrix tragende transparente Platte trennt, mit einem isolierenden Material gefüllt ist.

15. µLED-Display nach Anspruch 14, wobei das isolierende Material transparent ist.

16. µLED -Display nach Anspruch 14, wobei das isolierende Material opak ist.

17. µLED-Display nach einem der vorhergehenden Ansprüche, wobei die Chips alle identisch sind, wobei jeder Chip mindestens drei Leuchtdioden aufweist, wobei jede Leuchtdiode in einem anderen Spektralband emittiert als die beiden anderen Leuchtdioden.

18. µLED-Display nach einem der Ansprüche 1 bis 16, wobei die Chips von mindestens drei Typen sind, wobei jeder Chiptyp mehrere identische Leuchtdioden aufweist, wobei die Leuchtdioden eines Chiptyps in einem anderen Spektralband emittieren als die Leuchtdioden der beiden anderen Chiptypen.

## Claims

1. A µLED display having a plurality of electronic chips (10) with µLEDs and an active matrix (40) for controlling said chips with µLEDs, the active matrix being mounted on a transparent slide (2), each chip (10) with µLEDs having multiple light-emitting diodes (13), each chip with µLEDs comprising a substrate (11) having, on the lower portion thereof, a conductive surface (12) acting as a common electrode and, on the upper portion thereof, the µLEDs (13) and their individual electrical control contacts (14), wherein the display has at least, in this order:
- a support plate (1) having a lower face and an upper face;
- one or more first power supply planes (20) arranged on the upper face of the support plate;
- a plurality of first conductive elements (30);
- the plurality of electronic chips (10), a first conductive element providing the electrical connection between the common electrode of each chip and a first power supply plane;
- a plurality of second conductive elements (31), each second conductive element being arranged on an electrical contact for controlling an electronic chip;
- the transparent slide (2) bearing the active matrix (40), each second conductive element providing the electrical connection between an electrical contact of an electronic chip and an electrical contact (41) for controlling the active matrix.

2. The µLED display according to claim 1, wherein the power supply plane is common to all of the electronic chips.

3. The µLED display according to claim 1, wherein a second power supply plane is arranged on the lower face of the support plate.

4. The µLED display according to claim 3, wherein said second power supply plane is electrically connected to the upper face of the support plate by means of conductive vias providing the electrical connection between the first power supply plane and the second power supply plane.

5. The µLED display according to claim 3, wherein a heat dissipation element is attached under the support plate.

6. The µLED display according to claim 1, wherein a third power supply plane (23) is arranged on the lower face of the support plate, said third power supply plane being electrically connected by means of conductive vias (24) to metal or conductive lands, which are independent of the first electrical plane or of the second electrical plane, which are placed on the upper face of the support plate, a plurality of third conductive elements (32) providing the electrical connection between each via and an electrical contact for the power supply of the active matrix.

7. The µLED display according to claim 6, wherein the support plate is a multilayer printed circuit having multiple electrically insulated conductive layers.

8. The µLED display according to claim 6, wherein the support plate has compartments into which the electronic chips are inserted.

9. The µLED display according to claim 6, wherein the support plate has first conductive pads arranged on each via and whose height is equal to that of the electronic chips.

10. The µLED display according to claim 6, wherein the transparent slide has second conductive pads arranged facing each via and whose height is equal to that of the electronic chips.

11. The µLED display according to one of claims 1 to 5, wherein the support plate is transparent, the power supply planes being grids (21) having conductive pads (22) arranged under the µLEDs.

12. The µLED display according to claim 11, wherein the support plate is made of glass or of polyethylene terephthalate.

13. The µLED display according to claim 11, wherein the grids are covered with a light-absorbent material.

14. The µLED display according to one of the preceding claims, wherein the space separating the first power supply plane and the transparent slide bearing the active matrix is filled with an insulating material.

15. The µLED display according to claim 14, wherein the insulating material is transparent.

16. The µLED display according to claim 14, wherein the insulating material is opaque.

17. The µLED display according to one of the preceding claims, wherein the chips are all identical, each chip having at least three light-emitting diodes, each light-emitting diode emitting in a spectral band which is different from those of the two other light-emitting diodes.

18. The µLED display according to one of claims 1 to 16, wherein the chips are of at least three types, each type of chip having multiple identical light-emitting diodes, the light-emitting diodes of one type of chip emitting in a spectral band which is different from those of the light-emitting diodes of the two other types of chip.
